# EUROPEAN PATENT APPLICATION

(11) **EP 4 787 408 A1**
(43) Date of publication of application: **05.08.2026**
(21) Application number: 26154467.0
(22) Date of filing: 27.01.2026
(51) Int. Cl.: H01F 17/00, H01F 27/29, H01F 41/04, H01F 27/34, H01F 27/36

(54) **INDUCTOR ARRAY IN A SURFACE MOUNT DEVICE**

(30) Priority: 29.01.2025 US 202519040792
(71) Applicant: Avago Technologies International Sales Pte. Limited, Singapore 768923 (SG)
(72) Inventor: Tawa, Katsunori, San Jose, 95124 (US)
(74) Representative: Dilg, Haeusler, Schindelmann Patentanwaltsgesellschaft mbH

(57) **Abstract**

An example surface mount device (SMD) includes: an enclosure having contacts; first and second inductors disposed in the enclosure, the first inductor including a first coil electrically coupled between first and second ones of the contacts, the second inductor including a second coil electrically coupled between third and fourth ones of the contacts; the first coil including first conductors disposed on layers in the enclosure, the first conductors being electrically coupled; the second coil including second conductors disposed on the layers in the enclosure, the second conductors being electrically coupled; wherein each dimension of the first and second contacts is less than a corresponding dimension of the first coil and each dimension of the third and fourth contacts is less than a corresponding dimension of the second coil.

## Description

### BACKGROUND

There is an ever-growing need to reduce the size of electronic devices, which can result in less space available for its components. An electronic device can include components electrically and mechanically mounted to a printed circuit board (PCB). The components can include integrated circuits (ICs) and other discrete devices, including surface mount devices (SMDs). An SMD may be a component that can be electronically and mechanically mounted to a surface of a substrate, such as a PCB. An SMD can include conductive contacts that can registered with and soldered to contacts on the substrate. One type of SMD component can be an inductor. An inductor may be an electronic component that can store energy in a magnetic field when electric current flows between its terminals. It can be challenging to fabricate SMD inductors in smaller and smaller footprints on substrates.

### SUMMARY

In some embodiments, a surface mount device (SMD) can include an enclosure having contacts. The SMD can include first and second inductors disposed in the enclosure, the first inductor including a first coil electrically coupled between first and second ones of the contacts, the second inductor including a second coil electrically coupled between third and fourth ones of the contacts. The first coil can include first conductors disposed on layers in the enclosure, the first conductors being electrically coupled. The second coil can include second conductors disposed on the layers in the enclosure, the second conductors being electrically coupled. Each dimension of the first and second contacts can be less than a corresponding dimension of the first coil and each dimension of the third and fourth contacts is less than a corresponding dimension of the second coil.

In some embodiments, a printed circuit board (PCB) can include an integrated circuit (IC) and a surface mount device (SMD) electrically coupled to the IC. The SMD can include an enclosure having contacts. The SMD can include first and second inductors disposed in the enclosure, the first inductor including a first coil electrically coupled between first and second ones of the contacts, the second inductor including a second coil electrically coupled between third and fourth ones of the contacts. The first coil can include first conductors disposed on layers in the enclosure, the first conductors being electrically coupled. The second coil can include second conductors disposed on the layers in the enclosure, the second conductors being electrically coupled. Each dimension of the first and second contacts can be less than a corresponding dimension of the first coil and each dimension of the third and fourth contacts is less than a corresponding dimension of the second coil.

In some embodiments, a method of fabricating a surface mount device (SMD) can include patterning layers to form first and second inductors and contacts, the first inductor including a first coil electrically coupled between first and second ones of the contacts, the second inductor including a second coil electrically coupled between third and fourth ones of the contacts. The method can include forming an enclosure around the layers, the enclosure exposing the contacts. The first coil can include first conductors disposed on layers in the enclosure, the first conductors being electrically coupled. The second coil can include second conductors disposed on the layers in the enclosure, the second conductors being electrically coupled. Each dimension of the first and second contacts is less than a corresponding dimension of the first coil and each dimension of the third and fourth contacts is less than a corresponding dimension of the second coil.

### BRIEF DESCRIPTION OF THE DRAWINGS

Fig. 1 is a block diagram depicting electronic components on a substrate.
Fig. 2A is a side view of an inductor in an SMD enclosure.
Fig. 2B is a top view of the inductor of Fig. 2A.
Fig. 2C is a top view of a pair of inductors and on a substrate.
Figs. 3A-3F show inductors that can be used in an inductor array according to embodiments.
Fig. 4A is a top view of an inductor array according to some embodiments.
Fig. 4B is a top view of an inductor array according to some embodiments.
Fig. 4C is a side view of an inductor array according to some embodiments.
Fig. 5 is a top view of an inductor pair on a substrate in another example.
Fig. 6A is a top view of an inductor array in an SMD according to some embodiments.
Fig. 6B is a side view of the inductor array of Fig. 6A.
Fig. 6C is a bottom view of the inductor array of Fig. 6A.
Fig. 7A is a top view of an inductor array in an SMD according to some embodiments.
Fig. 7B is a side view of the inductor array of Fig. 7A.
Fig. 7C is a bottom view of the inductor array of Fig. 7A.
Fig. 8A is a top view of an inductor array in an SMD according to some embodiments.
Fig. 8B is a side view of the inductor array of Fig. 8A.
Fig. 8C is a bottom view of the inductor array of Fig. 8A.
Fig. 9 is a top view of an inductor array in an SMD according to some embodiments.
Fig. 10A is a side view of a shield according to some embodiments.
Fig. 10B is a side view of a shield according to further embodiments.
Figs. 11A-11C are a top view of an inductor array in an SMD according to some embodiments.
Fig. 12 is a flow diagram depicting a method of forming an inductor array in an SMD according to some embodiments.
Fig. 13 is a flow diagram depicting a method of forming an inductor array in an SMD according to further embodiments.

### DETAILED DESCRIPTION

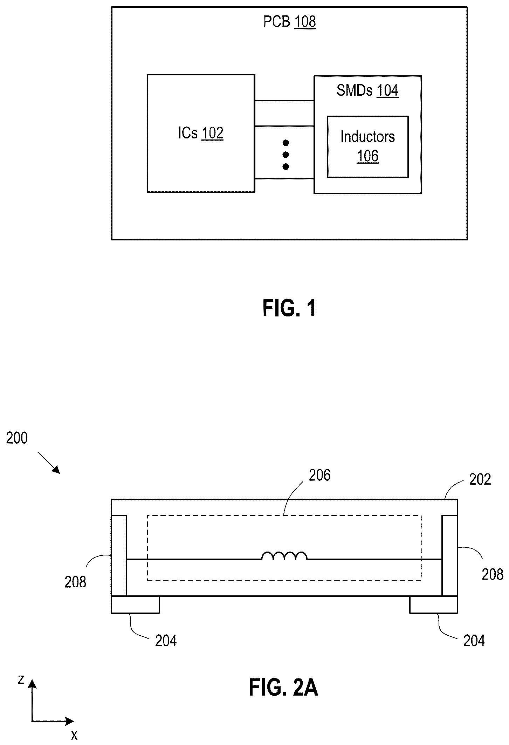

Fig. 1 is a block diagram depicting electronic components on a substrate. The electronic components can be electronically and mechanically mounted to a PCB 108. A PCB may be a laminated structure of conductive and insulating layers, where the conductive layers can be patterned with traces, planes, and other features. In the example, integrated circuits (ICs) 102 and SMDs 104 can be electronically and mechanically mounted to PCB 108. Soldering may be a process of joining two metal surfaces together using a metal referred to as solder and is a well-known technique for electronically and mechanically mounting electronic components to a substrate. SMDs 104 can be electrically coupled to ICs 102 through conductors of PCB 108. SMDs 104 can include inductors 106. An SMD inductor may be an inductor in an SMD enclosure, e.g., an inductor that can be mounted to a surface of a substrate (e.g., PCB 108). As opposed to through-hole inductors, which require leads to pass through holes in the substrate, SMD inductors can be formed in enclosures that allow for automated placement and soldering to the surface of the substrate. SMD inductors can be used in any of a myriad of modern electronic devices. SMD inductors can be used in various applications, such as filtering signals, energy storage, radio frequency (RF) applications (e.g., resonant inductor-capacitor circuits), chokes, and the like.

Fig. 2A is a side view of an inductor 200 in an SMD enclosure. Inductor 200 can include coil 206 formed in an enclosure 202. A coil may be a length of a conductor, or series of electrically coupled conductors, arranged in a sequence of rings. An enclosure may be dielectric material at least partially surrounding coil 206. An SMD enclosure may be an enclosure of an SMD. Inductor 200 can include contacts 204 exposed on the bottom surface of enclosure 202. A contact may be a conductor exposed on an enclosure. Contacts 204 can be conductors (e.g., metal). Inductor 200 can further include contacts 208 exposed on the side surfaces of enclosure 202. Inductor 200 can be soldered to a substrate (e.g., PCB 108) via contacts 204 and contacts 208. In the example, the side view is shown in an x-z plane. In examples herein, the directions left and right are with respect to the x-axis and an extent along the x-axis may be referred to as width. The directions top and bottom are with respect to the z-axis and an extent along the z-axis may be referred to as height. A y-axis (not shown) may be perpendicular to the x-z plane. The directions front and back are with respect to the y-axis and an extent along the y-axis may be referred to as length. On the left side, contacts 204 and 208 can be electrically coupled. Likewise, on the right side, contacts 204 and 208 can be electrically coupled. One pair of contacts 204, 208 can be one terminal of inductor 200 and the other pair of contacts 204, 208 can be another terminal of inductor 200. A terminal may be an end of a conductor of an electronic component. Coil 206 can be electrically coupled between terminals of inductor 200. Coil 206 can be formed from layers of patterned conductors separated by a dielectric material. Coil 206 can have extents along x, y, and z axes. Coil 206 can have various three-dimensional shapes and is shown schematically in Fig. 2A.

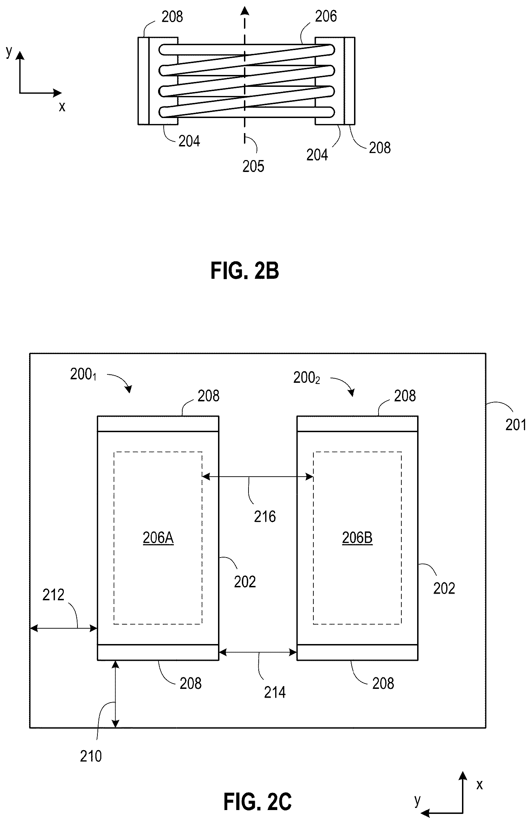

Fig. 2B is a top view of inductor 200. The top view is in the x-y plane. Coil 206 can be a series of conductors extending along the y-axis. One end of coil 206 can be electrically coupled to one pair of contacts 204, 208 and the other end of coil 206 can be electrically coupled to the other pair of contacts 204, 208. Current flows from one terminal to the other terminal of inductor 200. Magnetic flux 205 of inductor 200 in this example extends along the y-axis. Magnetic flux through a surface may be a measure of magnetic field lines passing through a closed surface (e.g., the portion of the x-z plane inside coil 206). In the example, depending on the direction of current through coil 206, magnetic flux 205 can have direction front to back or back to front. Other types of coils can be formed with magnetic flux along either the x-axis or the z-axis. In the example, contacts 204, 208 can be parallel with the y-axis and have a length equal to or approximately equal to the length of coil 206 (in coil form).

Fig. 2C is a top view of a pair of inductors 200₁ and 200₂ on a substrate (e.g., PCB 108). Each inductor 200₁ and 200₂ can be an SMD (e.g., in separate enclosures). Inductors 200₁ and 200₂ can occupy a footprint 201. A footprint may be area on a substrate that accommodates component(s) within a given set of constraints (e.g., design rules/specifications). Inductor 200₁ can include a coil 206A and inductor 200₂ can include a coil 206B, where the magnetic flux of coils 206A and 206B can be the same direction or different directions. A gap 216 between coils 206A and 206B can be selected to minimize mutual coupling between inductors 200₁ and 200₂. Two inductors can be mutually coupled when there is the induction of a voltage in one inductor in response to a change in current in the other inductor. The length of gap 216 that minimizes mutual coupling can depend on whether the magnetic flux of coil 206A is in the same direction as that of coil 206B or perpendicular to that of coil 206B. The length of gap 216 that minimizes mutual coupling can further depend on the inductance of the coils. If the magnetic flux is in the same direction, the length of gap 216 can be more than if the magnetic flux of one coil is perpendicular to that of the other coil. A gap 214 between contacts 208 can be selected to minimize the probability of an electrical short being formed during the soldering process. Likewise, gaps between the inductors and the edge of footprint 201 (e.g., gaps 210, 212) can be selected to minimize mutual coupling with and/or the probability of electrical shorts with other components on the substrate.

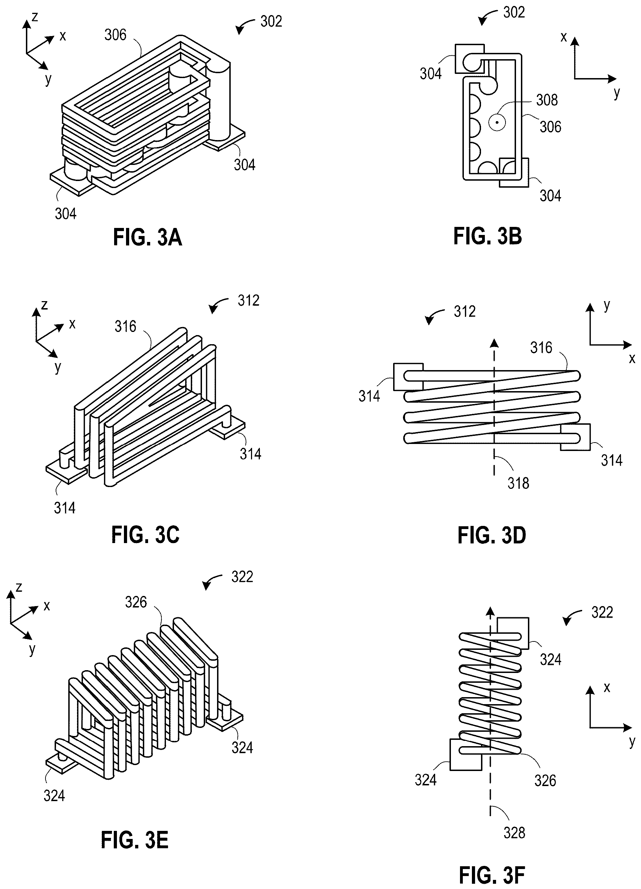

Figs. 3A-F show inductors that can be used in an inductor array according to embodiments. An inductor array may be a plurality of inductors in the same enclosure of an SMD. Note that inductors 200₁ and 200₂ (Fig. 2C) are not an inductor array as defined herein, since each inductor 200₁ and 200₂ is a separate SMD (not within the same enclosure of a single SMD). As described further herein, the inductors in Figs. 3A-F can be parts of an inductor array that occupy a reduced footprint on the substrate as compared to the same number of inductors in separate SMDs. That is, footprint 201 can be reduced as described further herein.

Figs. 3A-B show an inductor 302 according to some embodiments. Fig. 3A is an isometric view of inductor 302 and Fig. 3B is a top view of inductor 302. Inductor 302 can include a coil 306 electrically coupled between a pair of contacts 304. Coil 306 can include a plurality of rings stacked along the z-axis. Each ring has a length along the y-axis and a width along the x-axis. Coil 306 can be a series of conductors formed in patterned layers of conductors (which can be separated by dielectric material). The dielectric material is omitted from Figs. 3A-B for clarity. Pillars extending along the z-axis can be formed to connect one ring to another such that coil 306 is a series of conductors (e.g., the rings are electrically coupled to form a single coil). Contacts 304 can be formed at the bottom of inductor 302 (e.g., on a bottom-most conductive layer). Magnetic flux 308 can be perpendicular to the x-y plane (e.g., along the z-axis). The direction of magnetic flux 308 along the z-axis can depend on the direction of current through coil 306. In the example, the shape of the rings of coil 306 is generally rectangular. However, the rings can have other shapes, including other polygonal or circular/elliptical shapes. In some embodiments, all dimensions of contacts 304 are less than the corresponding dimensions of coil 306, e.g., the length of contact 304 is less than the length of coil 306 (in coil form); the width of contact 304 is less than the width of coil 306 (in coil form); and the height of contact 304 is less than the height of coil 306 (in coil form). As compared to inductor 200: the length of contact 304 is less than the length of coil 306, whereas the length of contact 204 is the same as or near the length of coil 206. Stated differently, the length of contact 304 as compared to coil 306 can be a fraction of the length of contact 204 as compared it coil 204. This can allow inductor 306 to be disposed closer to other inductors in an inductor array, as described further below.

Figs. 3C-D show an inductor 312 according to some embodiments. Fig. 3C is an isometric view of inductor 312 and Fig. 3D is a top view of inductor 312. Inductor 312 can include a coil 316 electrically coupled between a pair of contacts 314. Coil 316 can include a plurality of rings stacked along the y-axis. Each ring has a height along the z-axis and a width along the x-axis. Coil 316 can be a series of conductors formed in patterned layers of conductors (which can be separated by dielectric material). The dielectric material is omitted from Figs. 3C-D for clarity. Coil 316 can be a series of conductors (e.g., the rings are electrically coupled to form a single coil). Contacts 314 can be formed at the bottom of inductor 312 (e.g., on a bottom-most conductive layer). Magnetic flux 318 can be perpendicular to the x-z plane (e.g., along the y-axis). The direction of magnetic flux 318 along the y-axis can depend on the direction of current through coil 316. In the example, the shape of the rings of coil 316 is generally rectangular. However, the rings can have other shapes, including other polygonal or circular/elliptical shapes. In some embodiments, all dimensions of contacts 314 are less than the corresponding dimensions of coil 316, e.g., the length of contact 314 is less than the length of coil 316 (in coil form); the width of contact 314 is less than the width of coil 316 (in coil form); and the height of contact 314 is less than the height of coil 316 (in coil form).

Figs. 3E-F show an inductor 322 according to some embodiments. Fig. 3E is an isometric view of inductor 322 and Fig. 3F is a top view of inductor 322. Inductor 322 can include a coil 326 electrically coupled between a pair of contacts 324. Coil 326 can include a plurality of rings stacked along the x-axis. Each ring has a height along the z-axis and a length along the y-axis. Coil 326 can be a series of conductors formed in patterned layers of conductors (which can be separated by dielectric material). The dielectric material is omitted from Figs. 3E-F for clarity. Coil 326 can be a series of conductors (e.g., the rings are electrically coupled to form a single coil). Contacts 324 can be formed at the bottom of inductor 322 (e.g., on a bottom-most conductive layer). Magnetic flux 328 can be perpendicular to the y-z plane (e.g., along the x-axis). The direction of magnetic flux 328 along the x-axis can depend on the direction of current through coil 326. In the example, the shape of the rings of coil 326 is generally rectangular. However, the rings can have other shapes, including other polygonal or circular/elliptical shapes. In some embodiments, all dimensions of contacts 324 are less than the corresponding dimensions of coil 326, e.g., the length of contact 324 is less than the length of coil 326 (in coil form); the width of contact 324 is less than the width of coil 326 (in coil form); and the height of contact 324 is less than the height of coil 326 (in coil form).

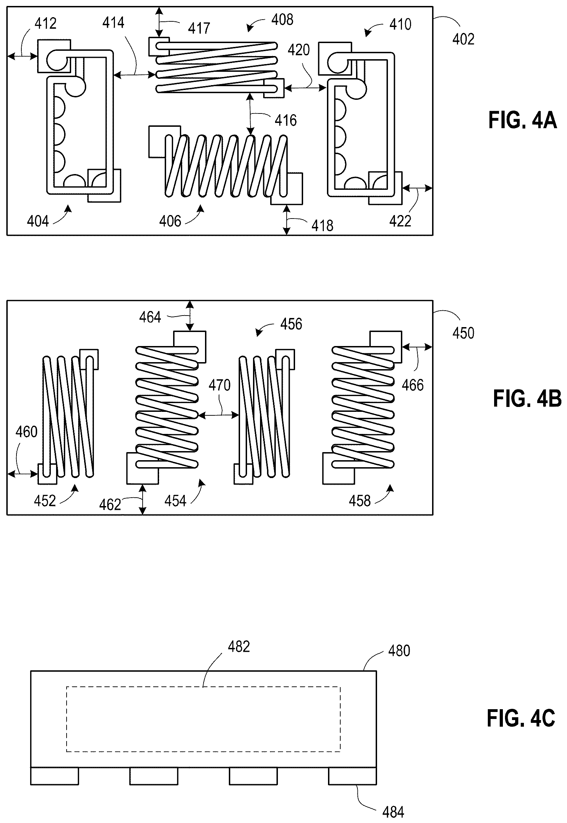

Fig. 4A is a top view of an inductor array according to some embodiments. The inductor array can include a plurality of inductors, e.g., four inductors 404, 406, 408, and 410 are shown. Inductors 404-410 can occupy a footprint 402, which can be the footprint of the SMD having the inductor array. In the example, each of inductors 402 and 410 can be the same or similar to inductor 302 (Figs. 3A-B); inductor 408 can be the same or similar to inductor 312 (Figs. 3C-D); and inductor 406 can be the same or similar to inductor 322 (Figs. 3E-F). Thus, adjacent inductors in the inductor array can have perpendicular magnetic flux. In other embodiments, some adjacent inductors in the inductor array can have magnetic flux in the same direction. The inductor array can have gaps between the inductor array and the edge of footprint 402 (which can correspond to the edge of the enclosure of the SMD), such as gaps 412, 417, 418, and 422. Gaps 412, 417, 418, and 422 can be less than gaps 210, 212 (Fig. 2), since the contacts of the inductors in the inductor array are disposed on the bottom of the enclosure of the SMD and contacts on the side are omitted. As noted above, the addition of side contacts can require that gaps 210, 212 be increased to reduce the probability of electrical shorts during soldering. Omitting the side contacts can remove this constraint on gaps 412, 417, 418, and 422. Gaps between inductors in the inductor array can be set to minimize mutual coupling, such as gaps 414, 416, and 420. The types and arrangement of inductors shown in Fig. 4A are exemplary and each inductor can have any shape or direction of magnetic flux.

Fig. 4B is a top view of an inductor array according to some embodiments. The inductor array in Fig. 4B is another example layout of inductors, e.g., four inductors 452, 454, 456, and 458 are shown. Inductors 452-458 can occupy a footprint 450, which can be the footprint of the SMD having the inductor array. In the example, inductors 452 and 456 can be the same or similar to inductor 312 (Figs. 3C-D), and inductors 454 and 458 can be the same or similar to inductor 322 (Figs. 3E-F). Thus, adjacent inductors in the inductor array can have perpendicular magnetic flux. In other embodiments, some adjacent inductors in the inductor array can have magnetic flux in the same direction. The inductor array can have gaps between the inductor array and the edge of footprint 450 (which can correspond to the edge of the enclosure of the SMD), such as gaps 460, 462, 464, and 466. Gaps 460-466 can be less than gaps 210, 212 (Fig. 2), since the contacts of the inductors in the inductor array are disposed on the bottom of the enclosure of the SMD and contacts on the side are omitted. As noted above, the addition of side contacts can require that gaps 210, 212 be increased to reduce the probability of electrical shorts during soldering. Omitting the side contacts can remove this constraint on gaps 460-466. Gaps between inductors in the inductor array can be set to minimize mutual coupling, such as gap 470. The types and arrangement of inductors shown in Fig. 4B are exemplary and each inductor can have any shape or direction of magnetic flux.

Fig. 4C is a side view of an inductor array according to some embodiments. The inductor array can be an SMD having an enclosure 480 and contacts 484. The inductor array can include inductors 482 formed in the enclosure using patterned conductive layers separated by dielectric material (e.g., any layout of inductors, such as that shown in Fig. 4A or 4B).

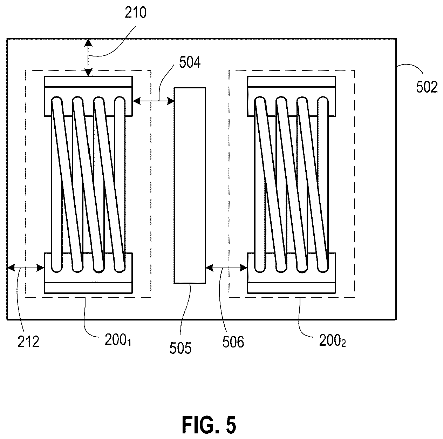

Fig. 5 is a top view of inductor pair 200₁ and 200₂ on a substrate (e.g., PCB 108) in another example. Each inductor 200₁ and 200₂ can be an SMD (e.g., in separate enclosures). Inductors 200₁ and 200₂ can occupy a footprint 502. Inductors 200₁ and 200₂ in this example can be the same and have magnetic flux in the same direction. To minimize mutual coupling, a shield 505 can be disposed between inductors 200₁ and 200₂. A shield can be a conductor or plurality of electrically coupled conductors. Shield 505 can be coupled to electrical ground. The layout can include a gap 504 between inductor 200₁ and shield 505 and a gap 506 between inductor 200₂ and shield 505. Gaps 504 and 506 can be set to minimize the probability of electrical shorts with shield 505 during soldering. Gaps between the inductors and the edge of footprint 502 are discussed above (e.g., Fig. 2C).

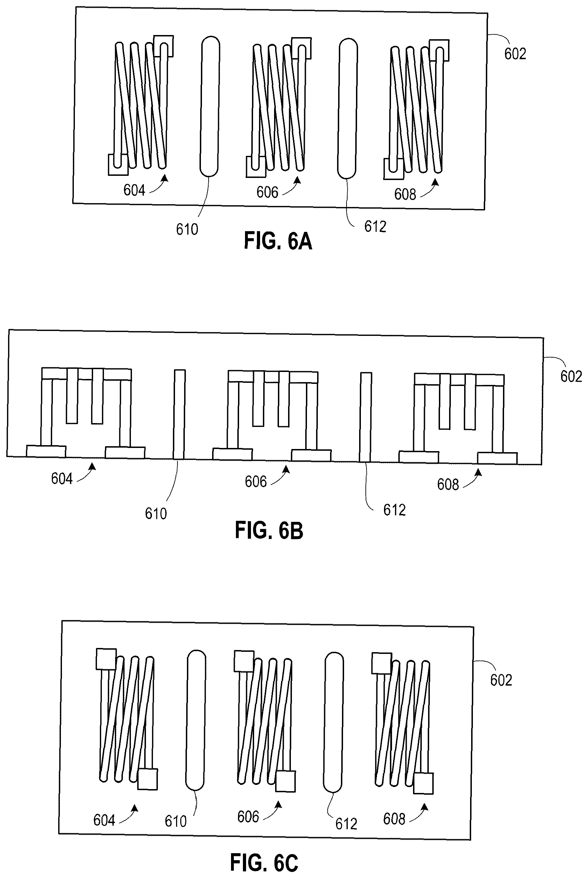

Fig. 6A is a top view of an inductor array in an SMD according to some embodiments. Fig. 6B is a side view of the inductor array of Fig. 6A. Fig. 6C is a bottom view of the inductor array of Fig. 6A. The inductor array includes inductors 604, 606, and 608 in an enclosure 602. The inductors 604, 606, and 608 can be the same or similar to inductor 312 shown in Figs. 3C-D. A shield 610 can be disposed between inductor 604 and inductor 606. A shield 612 can be disposed between inductor 606 and inductor 608. Shields 610 and 612 can be formed using conductors in the layers of SMD along with the conductors forming the coils. In some embodiments, inductors 604, 606, and 608 can have magnetic flux in the same direction. Mutual coupling can be mitigated by shields 610 and 612. Inductors 604, 606, and 608 can include contacts exposed outside the enclosure, as discussed above. The contacts can be disposed on a bottom layer and exposed on the bottom of the enclosure. In some embodiments, shields 610 and 612 can also be exposed on the bottom of the enclosure. This allows shields 610 and 612 to be coupled to electrical ground via the substrate (e.g., the PCB).

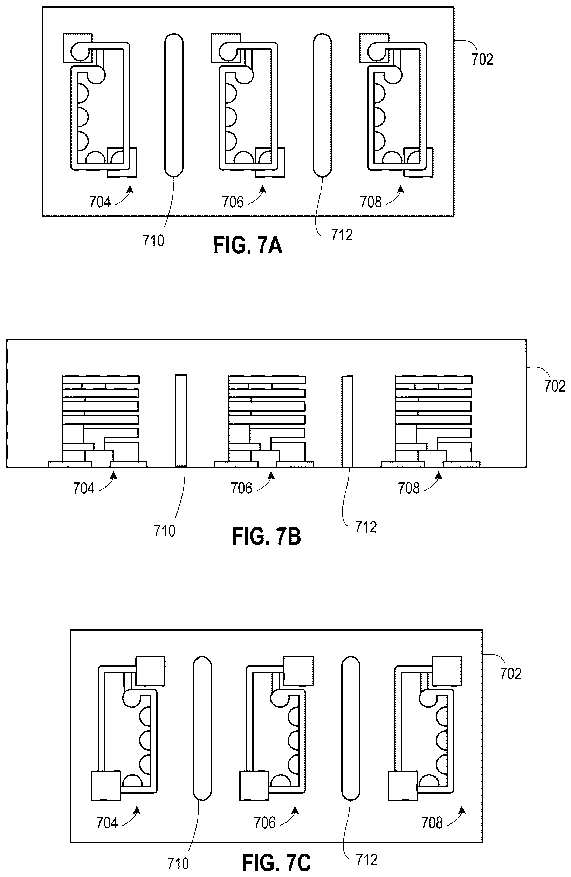

Fig. 7A is a top view of an inductor array in an SMD according to some embodiments. Fig. 7B is a side view of the inductor array of Fig. 7A. Fig. 7C is a bottom view of the inductor array of Fig. 7A. The inductor array includes inductors 704, 706, and 708 in an enclosure 702. The inductors 704, 706, and 708 can be the same or similar to inductor 302 shown in Figs. 3A-B. A shield 710 can be disposed between inductor 704 and inductor 706. A shield 712 can be disposed between inductor 706 and inductor 708. Shields 710 and 712 can be formed using conductors in the layers of SMD along with the conductors forming the coils. In some embodiments, inductors 704, 706, and 708 can have magnetic flux in the same direction. Mutual coupling can be mitigated by shields 710 and 712. Inductors 704, 706, and 708 can include contacts exposed outside the enclosure, as discussed above. The contacts can be disposed on a bottom layer and exposed on the bottom of the enclosure. In some embodiments, shields 710 and 712 can also be exposed on the bottom of the enclosure. This allows shields 710 and 712 to be coupled to electrical ground via the substrate (e.g., the PCB).

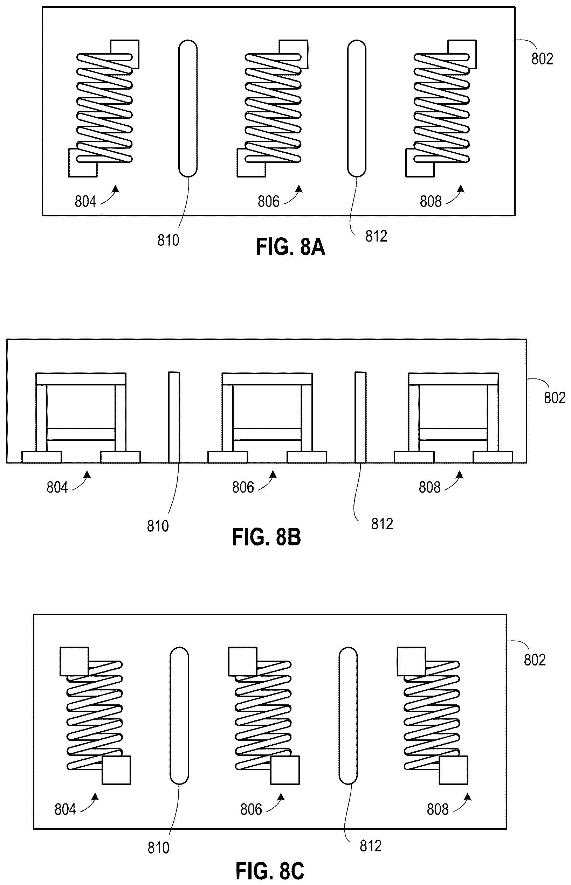

Fig. 8A is a top view of an inductor array in an SMD according to some embodiments. Fig. 8B is a side view of the inductor array of Fig. 8A. Fig. 8C is a bottom view of the inductor array of Fig. 8A. The inductor array includes inductors 804, 806, and 808 in an enclosure 802. The inductors 804, 806, and 808 can be the same or similar to inductor 322 shown in Figs. 3E-F. A shield 810 can be disposed between inductor 804 and inductor 806. A shield 812 can be disposed between inductor 806 and inductor 808. Shields 810 and 812 can be formed using conductors in the layers of SMD along with the conductors forming the coils. In some embodiments, inductors 804, 806, and 808 can have magnetic flux in the same direction. Mutual coupling can be mitigated by shields 810 and 812. Inductors 804, 806, and 808 can include contacts exposed outside the enclosure, as discussed above. The contacts can be disposed on a bottom layer and exposed on the bottom of the enclosure. In some embodiments, shields 810 and 812 can also be exposed on the bottom of the enclosure. This allows shields 810 and 812 to be coupled to electrical ground via the substrate (e.g., the PCB).

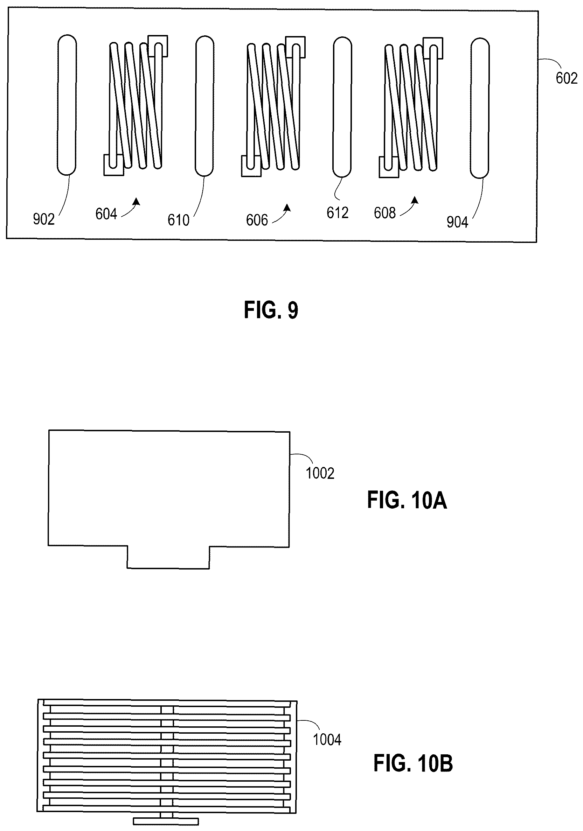

Fig. 9 is a top view of an inductor array in an SMD according to some embodiments. Elements of Fig. 9 that are the same or similar to those of Fig. 6A are designated with identical reference numerals and are described above. In the embodiment, additional shields 902 and 904 can be disposed in enclosure 602. Shield 902 can be disposed between inductor 604 and one edge of enclosure 602. Shield 904 can be disposed between inductor 608 and another edge of enclosure 602. Shields can be the same or similar to shields 610 and 612. While the embodiment is shown with respect to the layout of Fig. 6A, those skilled in the art will appreciate that the additional shields 902 and 904 can also be used in the embodiments of Fig. 7A and Fig. 8A described above.

Fig. 10A is a side view of a shield 1002 according to some embodiments. Shield 1002 can be used as any shield in the enclosure of an SMD as described herein. Shield 1002 comprises conductors formed on layers in the enclosure. The conductors can form a sheet (e.g., a conductive sheet) with little or no gaps between the conductors.

Fig. 10B is a side view of a shield 1004 according to some embodiments. Shield 1004 can be used as any shield in the enclosure of an SMD as described herein. Shield 1004 comprises conductors formed on layers in the enclosure. The conductors can be electrically connected. Shield 1004 can include gaps between the conductors.

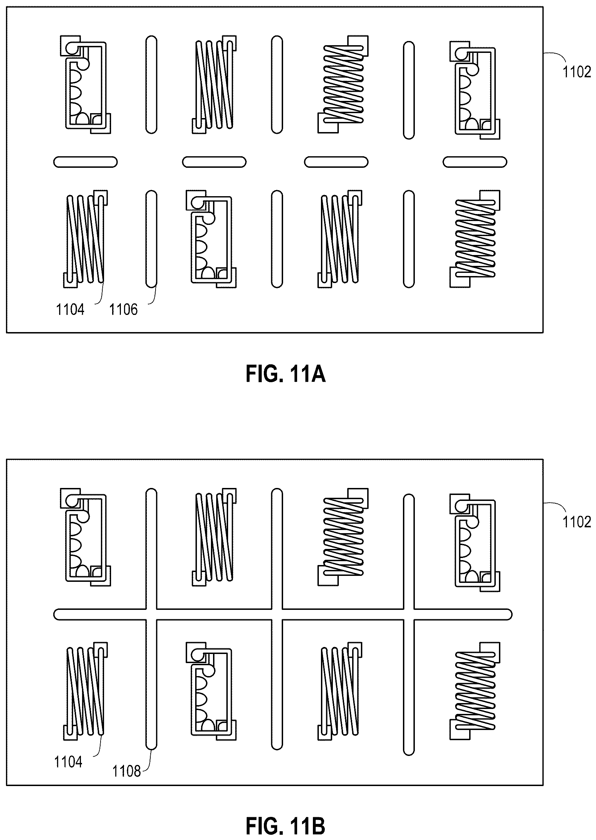

Fig. 11A is a top view of an inductor array in an SMD according to some embodiments. In the examples of Figs 7-9 above, the inductor array can include three inductors each having magnetic flux in the same direction. The inductors can also be arranged along one axis (e.g., the x axis). It is to be understood that the inductor array can include a plurality of inductors. The inductors in the array can have magnetic flux in the same direction or different directions. The inductors can be arranged along one axis or two axes. In the embodiment of Fig. 11A, the inductor array is disposed in an enclosure 1102. The inductor array can include eight inductors 1104 disposed along two axes (e.g., x and y axes). Adjacent ones of the inductors can have magnetic flux perpendicular to one another. Enclosure 1102 can include shields 1106 disposed between adjacent ones of inductors 1104. Shields 1106 can be disjoint from one another. Shields 1106 can be electrically coupled external to the SMD (e.g., by the substrate).

Fig. 11B is a top view of an inductor array in an SMD according to some embodiments. The inductor array in Fig. 11B is similar to that in Fig. 11A. However, in the embodiment, the shields between adjacent ones of the inductors are electrically coupled forming a single shield 1108.

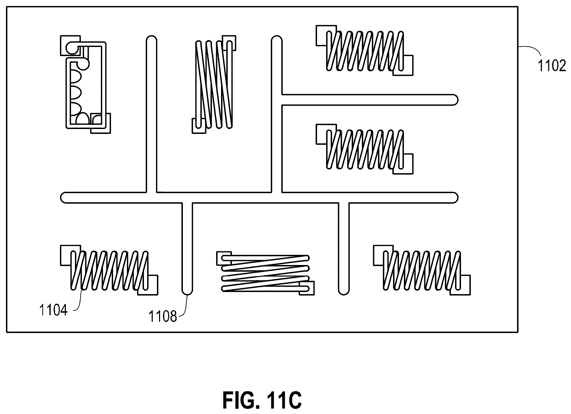

Fig. 11C is a top view of an inductor array in an SMD according to some embodiments. The inductor array in Fig. 11C is similar to that of Fig. 11B. However, in the embodiment, the arrangement of inductors 1104 is other than a "grid" along the two axes (e.g., the x and y axes). Any regular or irregular arrangement of inductors can be formed in enclosure 1102. In the embodiment, shield 1108 can be disposed between adjacent ones of inductors 1104. In other embodiments, disjoint shields can be used as shown in Fig. 11A.

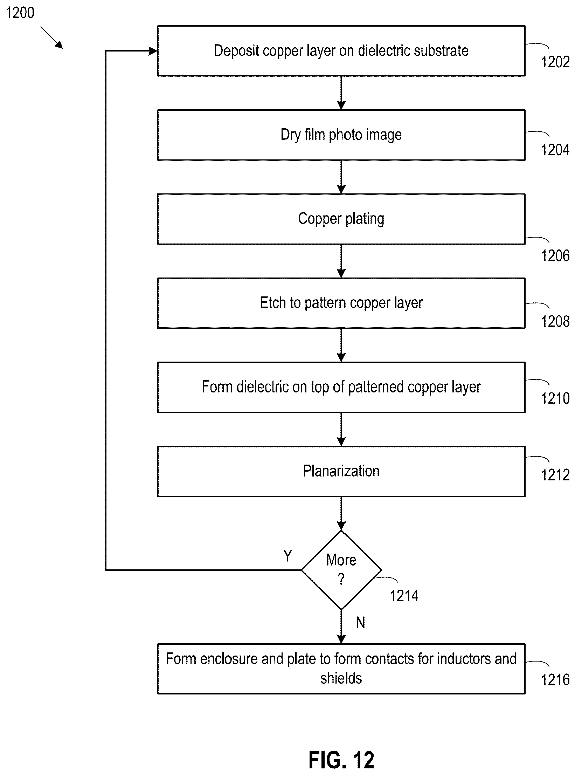

Fig. 12 is a flow diagram depicting a method 1200 of forming an inductor array in an SMD according to some embodiments. Method 1200 can be performed using conventional processing equipment known in the art. Method 1200 begins at step 1202, where a cooper layer can be deposited on a dielectric substrate. At step 1204, a photoimageable film can be deposited on the copper layer and photo imaged to form a pattern that exposes portions of the copper layer. At step 1206, copper plating can be performed in the portions that expose the copper layer. At step 1208, the photoimageable film can be etched to form a patterned conductive layer. At step 1210, a dielectric layer can be formed on top of the patterned conductive layer. At step 1212, the dielectric layer can be planarized. At step 1214, if there are more layers to be formed, method 1200 returns to step 1202 and repeats for another layer. Otherwise, method 1200 proceeds to step 1216. At step 1216, the enclosure can be formed and plating can be performed on the contacts of the enclosure (e.g., for inductor terminals and shields if present).

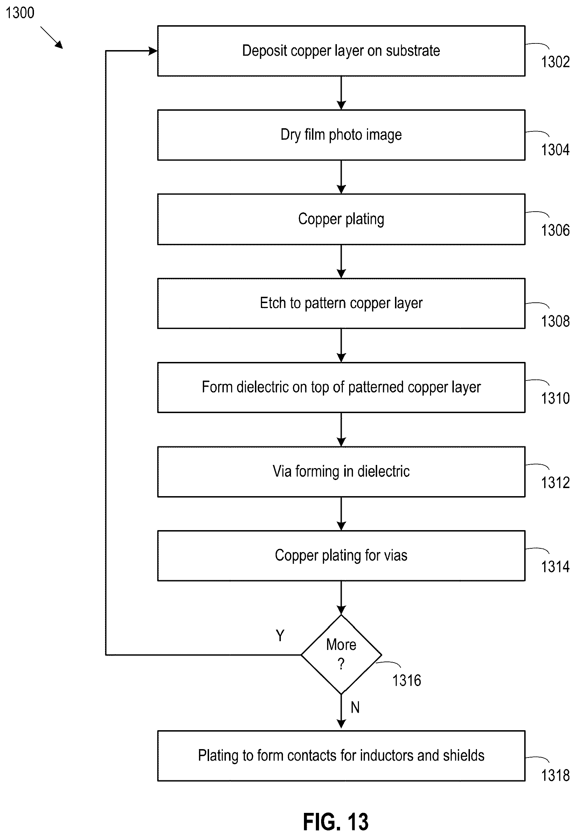

Fig. 13 is a flow diagram depicting a method 1300 of forming an inductor array in an SMD according to some embodiments. Method 1300 can be performed using conventional processing equipment known in the art. Method 1300 begins at step 1302, where a cooper layer can be deposited on a dielectric substrate. At step 1304, a photoimageable film can be deposited on the copper layer and photo imaged to form a pattern that exposes portions of the copper layer. At step 1306, copper plating can be performed in the portions that expose the copper layer. At step 1308, the photoimageable film can be etched to form a patterned conductive layer. At step 1310, a dielectric layer can be formed on top of the patterned conductive layer. At step 1312, vias can be formed in the dielectric material. At step 1314, copper plating can be formed the vias. The vias can connect one conductive layer to another conductive layer. At step 1316, if there are more layers to be formed, method 1300 returns to step 1302 and repeats for another layer. Otherwise, method 1300 proceeds to step 1318. At step 1318, the enclosure can be formed and plating can be performed on the contacts of the enclosure (e.g., for inductor terminals and shields if present).

While some processes and methods having various operations have been described, one or more embodiments also relate to a device or an apparatus for performing these operations. The apparatus may be specially constructed for required purposes, or the apparatus may be a general-purpose computer selectively activated or configured by a computer program stored in the computer. Various general-purpose machines may be used with computer programs written in accordance with the teachings herein, or it may be more convenient to construct a more specialized apparatus to perform the required operations.

As used herein, the phrase "at least one of" preceding a series of items, with the term "and" or "or" to separate any of the items, modifies the list as a whole, rather than each member of the list (i.e., each item). The phrase "at least one of" does not require selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C ," or alternatively, "at least one of A, at least one of B, and at least one of C," it is expressly described as such.

It will be understood that, although the terms "first," "second," etc. may be used herein to describe various elements, these elements should not be limited by these terms. These terms are only used to distinguish one element from another. For example, a first element could be termed a second element, and, similarly, a second element could be termed a first element, without departing from the scope of the present disclosure.

As used herein, the term "couple" and its derivatives include: (a) electrical, magnetic, and communicative coupling; and (b) do not imply a direct connection, but rather may include intervening elements, unless described as "directly coupled."

Although one or more embodiments of the present invention have been described in some detail for clarity of understanding, certain changes may be made within the scope of the claims. Accordingly, the described embodiments are to be considered as illustrative and not restrictive, and the scope of the claims is not to be limited to details given herein but may be modified within the scope and equivalents of the claims. In the claims, elements and/or steps do not imply any particular order of operation unless explicitly stated in the claims.

Boundaries between components, operations, and data stores are somewhat arbitrary, and particular operations are illustrated in the context of specific illustrative configurations. Other allocations of functionality are envisioned and may fall within the scope of the invention. In general, structures and functionalities presented as separate components in exemplary configurations may be implemented as a combined structure or component. Similarly, structures and functionalities presented as a single component may be implemented as separate components. These and other variations, additions, and improvements may fall within the scope of the appended claims.

## Claims

1. A surface mount device, SMD, comprising:
an enclosure having contacts;
first and second inductors disposed in the enclosure, the first inductor including a first coil electrically coupled between first and second ones of the contacts, the second inductor including a second coil electrically coupled between third and fourth ones of the contacts;
the first coil including first conductors disposed on layers in the enclosure, the first conductors being electrically coupled;
the second coil including second conductors disposed on the layers in the enclosure, the second conductors being electrically coupled;
wherein each dimension of the first and second contacts is less than a corresponding dimension of the first coil and each dimension of the third and fourth contacts is less than a corresponding dimension of the second coil.

2. The SMD of claim 1, wherein
the contacts are disposed on a bottom layer of the layers and are exposed on a bottom of the enclosure.

3. The SMD of claim 1 or 2, wherein
a first magnetic flux of the first coil is perpendicular to a second magnetic flux of the second coil.

4. The SMD of any one of the claims 1 to 3, further comprising:
a first shield disposed between the first and the second coils, the first shield comprising third conductors disposed on the layers in the enclosure.

5. The SMD of claim 4, wherein
the third conductors of the first shield combine to form a conductive sheet.

6. The SMD of claim 4, wherein
the third conductors of the first shield are electrically coupled and wherein the first shield includes gaps between the third conductors.

7. The SMD of claim 4, further comprising:
a second shield disposed between the first coil and a first edge of the enclosure; and
a third shield disposed between the second coil and a second edge of the enclosure.

8. The SMD of claim 4, wherein
the contacts are exposed on a bottom of the enclosure, the SMD further comprising:
a second shield disposed on a top and sides of the enclosure.

9. The SMD of any one of the claims 1 to 8, further comprising:
an array of inductors that includes the first inductor and the second inductor;
shields disposed in the enclosure between adjacent ones of the array of inductors.

10. The SMD of claim 9, wherein
the shields comprise conductors disposed on the layers in the enclosure, and
wherein the shields are disjoint in the enclosure.

11. The SMD of claim 9, wherein
the shields comprise conductors disposed on layers in the enclosure, and
wherein the shields are electrically coupled in the enclosure.

12. A printed circuit board, PCB, comprising:
an integrated circuit, IC);
a surface mount device, SMD, as set forth in any one of the preceding claims, the SMD being electrically coupled to the IC, wherein
the contacts are electrically and mechanically coupled to the PCB.

13. A method of fabricating a surface mount device (SMD), comprising:
patterning layers to form first and second inductors and contacts, the first inductor including a first coil electrically coupled between first and second ones of the contacts, the second inductor including a second coil electrically coupled between third and fourth ones of the contacts; and
forming an enclosure around the layers, the enclosure exposing the contacts;
wherein the first coil includes first conductors disposed on layers in the enclosure, the first conductors being electrically coupled, the second coil includes second conductors disposed on the layers in the enclosure, the second conductors being electrically coupled; and
wherein each dimension of the first and second contacts is less than a corresponding dimension of the first coil and each dimension of the third and fourth contacts is less than a corresponding dimension of the second coil.

14. The method of claim 13, wherein
the step of patterning comprises forming a first shield disposed between the first and the second coils, the first shield comprising third conductors disposed on the layers in the enclosure.
